# EUROPEAN PATENT APPLICATION

(11) **EP 1 811 370 A2**
(43) Date of publication of application: **25.07.2007**
(21) Application number: 06027048.5
(22) Date of filing: 29.12.2006
(51) Int. Cl.: G06F 5/06, G06F 5/16

(54) **A first-in first-out (FIFO) memory architecture providing multiport functionality**

(30) Priority: 30.12.2005 IN DE35402005
(71) Applicant: STMicroelectronics Pvt. Ltd., 201308 Greater Noida, Uttar Pradesh (IN)
(72) Inventor: Kapil, Batra, Noida UP (IN)
(74) Representative: Ferrari, Barbara

(57) **Abstract**

The present invention related to a first-in first-out (FIFO) memory architecture (10, 20) providing multiport functionality and comprising:
- a plurality of single-port memory structures (11, 21a, 21b);
- an indexing block (12, 22) for storing information about a single-port memory structure (11, 21a, 21b) in which incoming data is being stored in each data write operation; and
- an access controller (13, 23) for controlling operations on the single-port memory structures (11, 21a, 21b) based on the contents of the indexing block (12, 22).

A method of operating a plurality of single port memory structures (11, 21a, 21b) as a FIFO multiport memory architecture (10, 20) for sequential memory operations is also described.

## Description

### Field of the Invention

The present invention relates to a first-in first-out (FIFO) memory architecture providing multiport functionality.

More particularly, the invention relates to a first-in first-out (FIFO) memory of the type comprising a plurality of single-port memory structures suitably connected to form a multiport memory architecture.

### Background of the Invention

As it is well known, first-in first-out (FIFO) memories are commonly used in electronics system and VLSI circuits.

For instance, a FIFO memory can be used as a buffer between two circuits for asynchronous operations. In these cases, data may be written and read out simultaneously from FIFO memories with Input/ Output ports operating at different frequency.

Earlier, the drawback of such devices was that the data could not be received and written in a single clock cycle. To overcome this drawbacks of the single-port memories, dual-port FIFO were developed.

However, typical dual-port memories result in large penalty in terms of area, almost double than that of a single-port memory having the same dimensions. Moreover, dual-port FIFO memories can only be used for a single simultaneous read and write operation.

To overcome this problem FIFO memories with multiport functionality are being developed. Typical multiport FIFO memories provide functionality wherein multiple write operations and a single read operation may be performed in first-in first-out or FIFO mode. As in case of dual-port memory, the size of a multiport FIFO memory having the same dimensions is much bigger in comparison to the single-port or dual-port memories.

The technical problem underlying the present invention is that of providing a FIFO memory having structural and functional characteristics which allow to minimise its dimensions, in this way overcoming the limits which still affect the memories realised according to the prior art.

### Summary of the Invention

The solution idea underlying the present invention is that of providing a first-in first-out (FIFO) memory providing multiport functionality using single-port memory structures and thus resulting in reduced area.

On the basis of such solution idea the technical problem is solved by a first-in first-out (FIFO) memory architecture providing multiport functionality and comprising:
- a plurality of single-port memory structures;
- an indexing block for storing information about a single-port memory structure in which incoming data is being stored in each data write operation; and
- an access controller for controlling operations on the single-port memory structures based on the contents of the indexing block.

Advantageously according to the invention, the access controller comprises memory information storing a read and write pointer for each of the single port memory structures and for the indexing block.

Preferably, the indexing block comprises a plurality of flip-flops to store unique identification information corresponding to each of the single-port memory structures.

Moreover, advantageously according to the invention, first and second single-port memory structure are coupled to the access controller and to the indexing block to form a dual-port memory architecture (20).

The technical problem is also solved by a method of -operating a plurality of single port memory structures as a FIFO multiport memory architecture for sequential memory operations, the method comprising the steps of:
- maintaining a unique identification information corresponding to each single port memory structure comprised into the FIFO multiport memory architecture;
- performing a "read operation active" check to find a single port memory structure which is free for data write operation;
- storing the unique identification information corresponding to the single port memory structure as found in the previous "read operation active" check in which the data write operation is done in an indexing block; and
- performing data read operation based on the contents of the indexing block to ascertain the single port memory structure which has to be read.

Advantageously according to the invention, the sequential write operations are alternated between the single-port memory structures.

The characteristics and advantages of the first-in first-out (FIFO) memory providing multiport functionality and of the method of operating a plurality of single port memory structures as a multiport memory according to the invention will be apparent from the following description of an embodiment thereof given by way of indicative and non limiting example with reference to the annexed drawings.

### Brief Description of the Drawings

Figure 1 schematically illustrates a block diagram for a first-in first-out (FIFO) memory architecture providing multiport functionality in accordance with the present invention.
Figure 2 schematically illustrates a block diagram for the dual-port first-in first-out (FIFO) memory architecture in accordance with the present invention.

### Detailed Description of the Invention

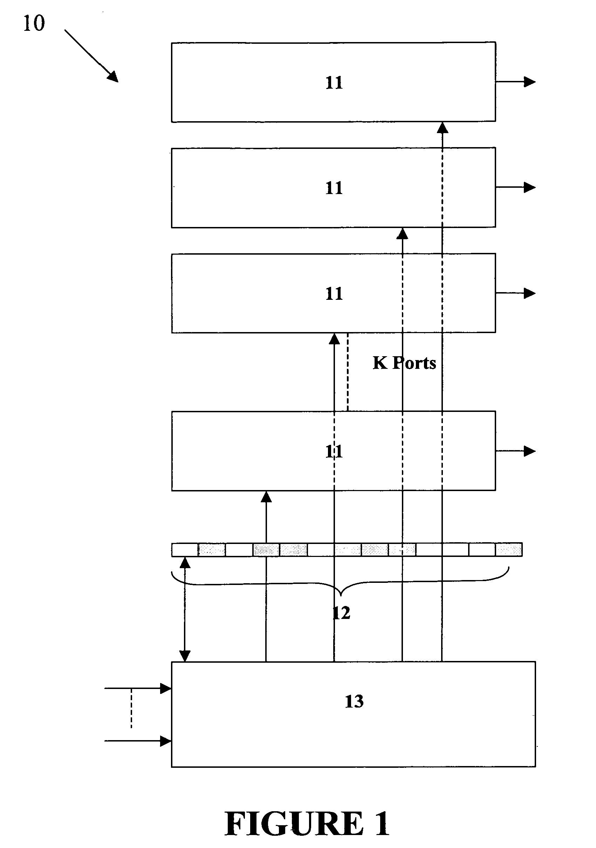

A FIFO memory with multiport-functionality is described and the same is schematically illustrated in Figure 1, globally indicated with 10. The proposed FIFO memory architecture 10 comprises multiple single-port memories or memory structures 11 and an indexing block 12 as well as a control logic namely an access controller 13 connected to the multiple single-port memory structures 11 and to the indexing block 12.

As will be clear from the following description, the FIFO memory architecture 10 according to the present invention provides multiport functionality.

More particularly, the FIFO memory architecture 10 utilizes at least two single-port memory structures 11 to provide multiport functionality and simultaneous sequential read and write operation capability. In this way, the FIFO memory architecture 10 of the present invention requires less silicon chip area in comparison to other FIFO memories providing dual or multiport functionality.

The multiple single-port memory structures 11 are coupled to the access controller 13 which maintains a pointer information for read and write operations in order for the architecture to act as a multiport FIFO memory. Moreover, the indexing block 12 stores memory identifier information corresponding to each single port memory structure 11.

Advantageously according to the invention, the indexing block 12 is used for storing information about one of the single-port memory structure 11 in which incoming data is being stored in each data write operation.

Moreover, the an access controller 13 controls operations on the single-port memory structures 11 based on the contents of the indexing block 12.

More particularly, the access controller 13 comprises memory information storing a read and write pointer for each of the single port memory structures 11 and for the indexing block 12.

For instance, the indexing block 12 comprises a plurality of flip-flops to store unique identification information corresponding to each of the single-port memory structures 11.

It should be noted that the number of bits in the indexing block 12 are dependent on number of FIFO memory locations as memory identifier information is required to be stored for each FIFO memory location. For instance, if K bits are required for storing the memory identifier information of the single-port memory structures 11 and the multiport FIFO memory architecture 10 has N locations, the indexing block 12 has ability of storing K×N bits.

The operation of the multiport FIFO memory architecture 10 according to the present invention will be now described.

During a write operation, the access controller 13 checks the availability of one of the multiple single-port memory structures 11 for a write operation, in a so called "read operation active" check.

Hence, at least one write operation is performed in an available single-port memory structure 11 as identified in the read operation active check. A memory identifier information corresponding to the identified single-port memory structure 11 in which the data write operation is performed is stored in the indexing block 12.

A write pointer for each single-port memory structure 11 is subsequently updated and maintained by the access controller 13.

The access controller 13 also prioritizes write locations and accordingly updates the indexing block 12 in case of multiple write operations in a single clock cycle.

For a read operation, the access controller 13 checks the indexing block 12 at the location of a read pointer of the multiport FIFO memory architecture 10.

A memory identifier which is stored in this location of the indexing block 12 is then used to "tell" the single-port memory structure 11 where the desired data is stored.

The access controller 13 is used to find a memory location within the selected single-port memory structure 11 and data is read from this location.

While a read operation is being performed, a "read operation active" flag is enabled in the access controller 13 to indicate unavailability of the corresponding single-port memory structure 11 for a write operation.

In this way, advantageously according to the invention, whenever there are simultaneous read and write operation requests on a same single-port memory 11, write operations would continue on the other available single-port memory structures 11 of the FIFO memory architecture 10.

The present invention thus also relates to a method of operating a plurality of single port memory structures 11 as a FIFO multiport memory architecture 10 for sequential memory operations. In particular, the method comprises the steps of:
- maintaining a unique identification information corresponding to each single port memory structure 11;
- performing a "read operation active" check to find a single port memory structure 11 which is free for data write operation;
- storing the unique identification information corresponding to the single port memory structure 11 as found in the previous "read operation active" check in which the data write operation is done in an indexing block 12; and
- performing data read operation based on the contents of the indexing block 12 to ascertain the single port memory structure 11 which has to be read.

Advantageously according to the method of the present invention, sequential write operations are alternated between the single-port memory structures 11 of the FIFO memory architecture 10.

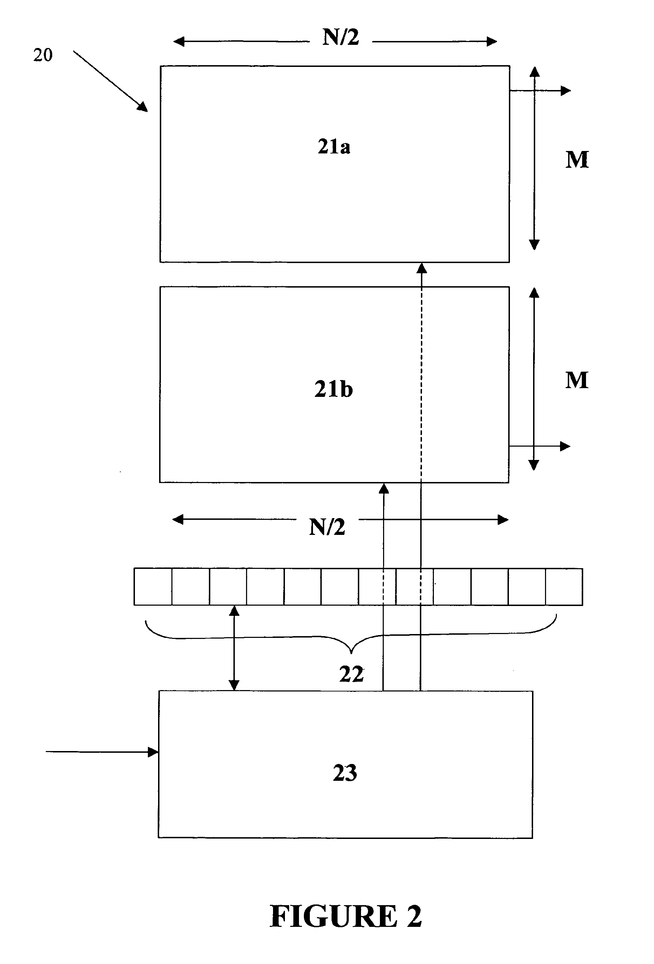

According to an alternative embodiment of the present invention, a FIFO memory architecture with dual-port functionality is described and schematically illustrated in Figure 2, globally indicated with 20.

The dual-port FIFO memory architecture 20 comprises two single-port memory structures, 21a and 21 b, an indexing block 22 and control logic namely an access controller 23.

In essence, a first and a second single-port memory structure, 21a and 21b, are coupled to the access controller 23 and to the indexing block 22 to form the dual-port memory architecture 20.

It should be noted that the single-port memory structures, 21a and 21b, the access controller 23 and the indexing block 22 correspond to the single-port memory structures 11, the access controller 13 and the indexing block 12 of the FIFO memory architecture 10 and their features as described with reference to Figure 1 will not be repeated for sake of simplicity.

As a non limitative example, a dual-port FIFO memory architecture 20of size N (depth) x M (width) is considered. In this case, the dual-port FIFO memory architecture 20 comprises two single-port memory structures of size N/2 x M.

Moreover, an N x 1 index 22 is used, being for instance implemented using flip-flops.

The operation of the dual-port FIFO memory architecture 20 according to the alternative embodiment of the present invention will be now described.

Whenever a write occurs, an index bit corresponding to a write address for the dual-port FIFO memory architecture 20 is updated and it reflects the single-port memory structure, 21a or 21 b, in which the write has been done.

In Figure 2, a grey block of the indexing block 22 corresponds to a write in the first single-port memory structure 21 a and a blank block corresponds to a write in the second single-port memory structure 21b.

When a read occurs (valid read enable), the bit-in the indexing block 22 corresponding to a read address is decoded by the access controller 23 to select the appropriate one of the single-port memory structures, 21a or 21b.

Before every write, a "busy due to ongoing read" check is done on the single-port memory structure, for instance the first single-port memory structure 21a, which is currently required for write operations.

In case such a first single-port memory structure 21a is busy with a read operation, further write operations are diverted to the other single-port memory structure 21 b available.

So whenever there are simultaneous read and write operation requests, write operations would continue on the other available memory i.e. memory select for write will toggle.

It is understood that Figure 2 is intended as an example of a FIFO memory in accordance with the present invention and not as an architectural limitation to the present invention. Those of ordinary skill in the art will appreciate that various combinations and arrangements may be employed without departing from the scope of the invention.

According to another embodiment, single-port FIFO memories may be used in the architecture to further reduce the complexity of the access controller and the single-port memories used. According to yet another embodiment, the write operation may be alternated between multiple memories when there is no read operation in progress. This would result in almost same number of used locations in all single-port memories. The FIFO memory architecture of the present invention requires less area as only single port memories are used as against dual port memories which have significantly larger area.

In summary, a memory may require buffering mechanism in which data can be written and read at the same time and thus require a multiport FIFO memory, which has multiple ports, able to provide simultaneous read & write operations. Since known multiport memories have a large penalty on area, a technique is proposed for avoiding use of multiport memories for designs, which requires sequential read and write operations. In this technique multiple single-port memory structures are used to form a multiport memory architecture.

It should be remarked that the FIFO memory architecture according to the present invention requires additional control logic but consumes significantly lower silicon area.

It is believed that the present invention and many of its attendant advantages will be understood by the foregoing description. It is also believed that it will be apparent that various changes may be made in the form, construction and arrangement of the components thereof without departing from the scope and spirit of the invention or without sacrificing all of its material advantages. The form herein before described being merely an exemplary embodiment thereof, it is the intention of the following claims to encompass and include such changes.

## Claims

1. A first in first-out (FIFO) memory architecture (10, 20) providing multiport functionality and comprising:
- a plurality of single-port memory structures (11, 21a, 21 b);
- an indexing block (12, 22) for storing information about a single-port memory structure (11, 21a, 21 b) in which incoming data is being stored in each data write operation; and
- an access controller (13, 23) for controlling operations on said single-port memory structures (11, 21a, 21b) based on the contents of said indexing block (12, 22).

2. A FIFO memory architecture (10, 20) according to claim 1, wherein said access controller (13, 23) comprises memory information storing a read and write pointer for each of said single port memory structures (11, 21a, 21b) and for said indexing block (12, 22).

3. A FIFO memory architecture (10, 20) according to in claim 1, wherein said indexing block (12, 22) comprises a plurality of flip-flops to store unique identification information corresponding to each of said single-port memory structures (11, 2 1 a, 21b).

4. A FIFO memory architecture (10, 20) according to claim 1, wherein first and second single-port memory structure (21a, 21 b) are coupled to said access controller (23) and said indexing block (22) to form a dual-port memory architecture (20).

5. A method of operating a plurality of single port memory structures (11, 21a, 21b) as a FIFO multiport memory architecture (10, 20) for sequential memory operations, said method comprising the steps of:
- maintaining a unique identification information corresponding to each single port memory structure (11, 21a, 21b) comprised into said FIFO multiport memory architecture (10, 20);
- performing a "read operation active" check to find a single port memory structure (11, 21a, 21b) which is free for data write operation;
- storing the unique identification information corresponding to the single port memory structure (11, 21a, 21b) as found in the previous "read operation active" check in which the data write operation is done in an indexing block (12); and
- performing data read operation based on the contents of said indexing block (12) to ascertain the single port memory structure (11, 21a, 21b) which has to be read.

6. A method of operating a plurality of single port memory structures (11, 21a, 21b) according to claim 5, wherein sequential write operations are alternated between said single-port memory structures (11, 21a, 21b).
